# EUROPEAN PATENT APPLICATION

(11) **EP 4 707 707 A1**
(43) Date of publication of application: **11.03.2026**
(21) Application number: 24882661.2
(22) Date of filing: 23.09.2024
(51) Int. Cl.: F25D 15/00, F25D 23/00, F25D 23/06, F25B 21/02, F28D 21/00

(54) **REFRIGERATOR**

(30) Priority: 27.10.2023 KR 20230146083
(71) Applicant: Samsung Electronics Co., Ltd., Suwon-si, Gyeonggi-do 16677 (KR)
(72) Inventor: LEE, Jaehwan, Suwon-si Gyeonggi-do 16677 (KR); SONG, Haejin, Suwon-si Gyeonggi-do 16677 (KR); JEONG, Heemoon, Suwon-si Gyeonggi-do 16677 (KR)
(74) Representative: Gulde & Partner
(86) International application number: PCT/KR2024/014269
(87) International publication number: WO 2025/089632

(57) **Abstract**

A refrigerator may include a body including an insulating wall having a hole, a compartment in the body, and a thermoelectric module in the hole and configured to cool the compartment the thermoelectric module includes a thermoelectric element including: a heat-absorbing surface on a first side facing and configured to absorb heat from the compartment, a heat-generating surface on a second side, opposite the first side, and configured to receive heat from the heat-absorbing surface and discharge the received heat, a cooling sink in contact with the heat-absorbing surface and configured to exchange heat with the heat-absorbing surface, a heat sink in contact with the heat-generating surface and configured to exchange heat with the heat-generating surface, and a coupling member coupling the cooling sink and heat sink so that the cooling sink is pressed against the heat-absorbing surface and the heat sink is pressed against the heat-generating surface.

## Description

### [Technical Field]

The disclosure relates to a refrigerator, and more particularly, to a refrigerator that uses a thermoelectric element to cool a storage compartment.

### [Background Art]

In general, a refrigerator, an appliance for keeping food fresh, includes a main body having a storage compartment and a cold air supply device for supplying cold air to the storage compartment.

The refrigerator may use a thermoelectric element as the cold air supply device, the thermoelectric element generating heating and cooling by means of the Peltier effect. The Peltier effect is a phenomenon in which the flow of heat is induced by the flow of electric current.

The thermoelectric element has a heat-absorbing surface and a heat-generating surface, and when a current is applied to the thermoelectric element, heat may be transferred from the heat-absorbing surface to the heat-generating surface, resulting in a temperature difference between the heat-absorbing surface and the heat-generating surface. Accordingly, the storage compartment may be cooled by absorbing heat from the storage compartment through the heat-absorbing surface.

A cooling sink may be attached to the heat-absorbing surface to ensure efficient heat absorption, and a heat sink may be attached to the heat-generating surface to ensure efficient heat generation.

### [Disclosure]

### [Technical Problem]

An aspect of the present disclosure provides a refrigerator including a thermoelectric module that more effectively cools a storage compartment.

Further, an aspect of the present disclosure provides a thermoelectric module with improved ease of assembly, coupling strength, and durability.

Further, an aspect of the present disclosure provides a refrigerator including a thermoelectric module having a structure capable of being reliably seated in an insulating wall.

Technical tasks to be achieved in this document are not limited to the technical tasks mentioned above, and other technical tasks not mentioned will be clearly understood by those skilled in the art from the description below.

### [Technical Solution]

According to an embodiment of the present disclosure, a refrigerator may include a main body including an insulating wall having a hole therethrough; a storage compartment in the main body; and a thermoelectric module in the hole, seated on the insulating wall, and configured to cool the storage compartment; wherein the thermoelectric module includes: a thermoelectric element including a heat-absorbing surface on a first side of the thermoelectric module facing the storage compartment and configured to absorb heat from the storage compartment, and a heat-generating surface on a second side of the thermoelectric module, opposite the first side, and configured to receive heat from the heat-absorbing surface and discharge the received heat, a cooling sink in contact with the heat-absorbing surface and configured to exchange heat with the heat-absorbing surface, a heat sink in contact with the heat-generating surface and configured to exchange heat with the heat-generating surface, and a coupling member coupling the cooling sink and the heat sink so that the cooling sink is pressed against the heat-absorbing surface and the heat sink is pressed against the heat-generating surface.

The cooling sink may have a cooling sink coupling hole therethrough, the heat sink may have a heat sink coupling hole therethrough, and the coupling member may include: a first coupling portion that may pass through the cooling sink coupling hole and the heat sink coupling hole, a second coupling portion that may be connected to a first end of the first coupling portion and may be configured to be supported on the first side of the thermoelectric module, and a third coupling portion that may be connected to a second end of the first coupling portion and may be configured to be supported on the second side of the thermoelectric module, and the second coupling portion or the third coupling portion may be configured to be movable toward the thermoelectric element to press the cooling sink against the heat-absorbing surface and to press the heat sink against the heat-generating surface.

The first coupling portion may include a bolt body, the second coupling portion may include a nut, and the third coupling portion may include a bolt head.

The refrigerator may further include: a module frame along an inner circumferential surface of the hole and that may be secured to the insulating wall, wherein the thermoelectric module may be coupled to the module frame.

The thermoelectric module may include a plurality of thermoelectric modules, and the refrigerator may include at least one connector connecting the plurality of thermoelectric modules to each other.

The plurality of thermoelectric modules may include a plurality of heat sinks, and the at least one connector may connect the plurality of thermoelectric modules to each other by coupling to the plurality of heat sinks to each other.

The connector may be coupled to a side of each heat sink of the plurality of heat sinks that faces away from the storage compartment.

The refrigerator may further include: an insulation having a through hole, wherein the thermoelectric element may be in the through hole, and the insulation may be between the cooling sink and the heat sink.

The insulation may include: a first cover plate that may cover a first insulation surface that faces the cooling sink, and a second cover plate that may cover a second insulation surface that faces the heat sink, and the first cover plate may contact a side of the cooling sink facing the insulation, and the second cover plate may contact a side of the heat sink facing the insulation.

An outer circumferential surface of the insulation may contact an inner circumferential surface of the module frame.

The insulation may include: a first insulation surface facing the cooling sink, and a second insulation surface facing the heat sink, the first insulation surface may have a smaller area than the second insulation surface, an outer circumferential surface of the insulation may be inclined from an outer circumference of the second insulation surface toward an outer circumference of the first insulation surface, and an inner circumferential surface of the module frame may include a shape corresponding to the outer circumferential surface of the insulation and may be in contact with the outer circumferential surface of the insulation.

The cooling sink may include: a cooling plate that may contact the first cover plate, and a cooling block that may protrude from the cooling plate into the through hole, the heat sink may include a heating plate contacting the second cover plate, and the thermoelectric element may be arranged so that the heat-absorbing surface may contact the cooling block and the heat-generating surface may contact the heating plate.

The insulating wall may include: an inner opening on a first side of the insulating wall facing toward the storage compartment, and an outer opening on a second side of the insulating wall facing away from the storage compartment, opposite to the first side, the hole may extend from the inner opening to the outer opening, and the thermoelectric element may be closer to the outer opening than the inner opening.

The heat sink may be secured to the module frame to couple the thermoelectric module to the module frame.

The cooling sink may have a cooling sink coupling hole therethrough, the heat sink may have a heat sink coupling hole therethrough, the thermoelectric module may include: a first cover that may cover outside a circumference of the cooling sink coupling hole on a side of the cooling sink, and a second cover that may cover outside a circumference of the heat sink coupling hole on a side of the heat sink, and the first cover and the second cover may include an insulating material.

According to an embodiment of the present disclosure, a refrigerator includes a main body including a plurality of insulating walls. The refrigerator includes a storage compartment formed within the main body. The refrigerator includes a plurality of thermoelectric modules seated on any one of the plurality of insulating walls, the plurality of thermoelectric modules inserted into the hole and configured to cool the storage compartment. Each of the plurality of thermoelectric modules includes a thermoelectric element including a heat-absorbing surface formed on one side facing the storage compartment to absorb heat from the storage compartment and a heat-generating surface formed on the opposite side to emit the heat absorbed by the heat-absorbing surface. Each of the plurality of thermoelectric modules includes a cooling sink in contact with the heat-absorbing surface to exchange heat with the heat-absorbing surface. Each of the plurality of thermoelectric modules includes a heat sink in contact with the heat-generating surface to exchange heat with the heat-generating surface. Each of the plurality of thermoelectric modules includes a coupling member configured to couple the cooling sink and the heat sink to allow the cooling sink and the heat sink to be respectively pressed against the thermoelectric element side.

### [Description of Drawings]

FIG. 1 is a view illustrating a refrigerator according to an embodiment.
FIG. 2 is an exploded view illustrating a plurality of insulating walls of the refrigerator according to an embodiment.
FIG. 3 is a view illustrating a module assembly and a module frame separated from the insulating walls, according to an embodiment.
FIG. 4 is a view illustrating the module assembly, according to an embodiment.
FIG. 5 is a view illustrating the module assembly separated, according to an embodiment.
FIG. 6 is a view of FIG. 5 from a different angle.
FIG. 7 is a rear view illustrating the module assembly according to an embodiment.
FIG. 8 is a rear view of a module assembly according to an embodiment.
FIG. 9 is a side cross-sectional view illustrating a thermoelectric module, according to an embodiment.
FIG. 10 is an exploded view illustrating the insulation according to an embodiment.
FIG. 11 is a side cross-sectional view illustrating a rear insulating wall, according to an embodiment.
FIG. 12 is an enlarged view illustrating a portion of a side cross-section of the rear insulating wall, according to an embodiment.
FIG. 13 is an enlarged view illustrating a portion of the side cross-section of a rear insulating wall, according to an embodiment.

### [Modes of the Invention]

Various embodiments of the present document and terms used therein are not intended to limit the technical features described in this document to specific embodiments, and should be understood to include various modifications, equivalents, or substitutes of the corresponding embodiments.

In connection with the description of the drawings, similar reference numerals may be used for similar or related components.

The singular form of a noun corresponding to an item may include one or a plurality of the items unless clearly indicated otherwise in a related context.

In this document, phrases, such as "A or B", "at least one of A and B", "at least one of A or B," "A, B or C," "at least one of A, B and C," and "at least one of A, B, or C", may include any one or all possible combinations of items listed together in the corresponding phrase among the phrases.

As used herein, the term "and/or" includes any and all combinations of one or more of associated listed items.

Terms such as "1st", "2nd", "primary", or "secondary" may be used simply to distinguish a component from other components, without limiting the component in other aspects (e.g., importance or order).

Further, as used in the disclosure, the terms "front", "rear", "top", "bottom", "side", "left", "right", "upper", "lower", and the like are defined with reference to the drawings, and are not intended to limit the shape and position of each component.

It will be understood that when the terms "includes," "comprises," "including," and/or "comprising," when used in this specification, specify the presence of stated features, figures, steps, operations, components, members, or combinations thereof, but do not preclude the presence or addition of one or more other features, figures, steps, operations, components, members, or combinations thereof.

It will be understood that when a certain component is referred to as being "connected to", "coupled to", "supported by" or "in contact with" another component, it can be directly or indirectly connected to, coupled to, supported by, or in contact with the other component. When a component is indirectly connected to, coupled to, supported by, or in contact with another component, it may be connected to, coupled to, supported by, or in contact with the other component through a third component.

It will also be understood that when a component is referred to as being "on" another component, it can be directly on the other component or intervening components may also be present.

A refrigerator according to an embodiment of the disclosure may include a main body.

The "main body" may include an inner case, an outer case positioned outside the inner case, and an insulation provided between the inner case and the outer case.

The "inner case" may include a case, a plate, a panel, or a liner forming a storage compartment (also referred to as a storage room). The inner case may be formed as one body, or may be formed by assembling a plurality of plates together. The "outer case" may form an appearance of the main body, and be coupled to an outer side of the inner case such that the insulation is positioned between the inner case and the outer case.

The "insulation" may insulate inside of the storage compartment from outside of the storage compartment to maintain inside temperature of the storage compartment at appropriate temperature without being influenced by an external environment of the storage compartment. According to an embodiment of the disclosure, the insulation may include a foaming insulation. The foaming insulation may be molded by fixing the inner case and the outer case with jigs, etc. and then injecting and foaming urethane foam as a mixture of polyurethane and a foaming agent between the inner case and the outer case.

According to an embodiment of the disclosure, the insulation may include a vacuum insulation in addition to a foaming insulation, or may be configured only with a vacuum insulation instead of a forming insulation. The vacuum insulation may include a core material and a cladding material accommodating the core material and sealing the inside with vacuum or pressure close to vacuum. The vacuum insulation may further include an adsorbent for adsorbing a gas and water to stably maintain a vacuum state. However, the insulation is not limited to the above-mentioned foaming insulation or vacuum insulation, and may include various materials capable of being used for insulation.

The "storage compartment" may include a space defined by the inner case. The storage compartment may further include the inner case defining the space. The storage compartment may store various items, such as medicines or cosmetics, as well as food items, may be stored in the storage compartment, and one side of the storage compartment may be open to enable a user to put items in or out.

The refrigerator may include one or more storage compartments. In a case in which two or more storage compartments are formed in the refrigerator, the respective storage compartments may have different purposes of use, and may be maintained at different temperature. To this end, the storage compartments may be partitioned by a partition wall including an insulation.

The storage compartment may be maintained within an appropriate temperature range according to a purpose of use, and include a "refrigerating compartment", a "freezing compartment", and a "temperature conversion compartment" according to purposes of use and/or temperature ranges. The refrigerating compartment may be maintained at appropriate temperature to keep food refrigerating, and the freezing compartment may be maintained at appropriate temperature to keep food frozen. The "refrigerating" may be keeping food cold without freezing the food, and for example, the refrigerating compartment may be maintained within a range of 0 degrees Celsius to 7 degrees Celsius. The "freezing" may be freezing food or keeping food frozen, and for example, the freezing compartment may be maintained within a range of -20 degrees Celsius to -1 degrees Celsius. The temperature conversion compartment may be used as any one of a refrigerating compartment or a freezing compartment according to or regardless of a user's selection.

The storage compartment may also be called various other terms, such as "vegetable compartment", "freshness compartment", "cooling compartment", and "ice-making compartment", in addition to "refrigerating compartment", "freezing compartment", and "temperature conversion compartment", and the terms, such as "refrigerating compartment", "freezing compartment", "temperature conversion compartment", etc., as used below need to be understood to represent storage compartments having the corresponding purposes of use and the corresponding temperature ranges.

The refrigerator according to an embodiment of the disclosure may include at least one door configured to open or close the open side of the storage compartment. The respective doors may be provided to open and close one or more storage compartments, or a single door may be provided to open and close a plurality of storage compartments. The door may be rotatably or slidably mounted on the front of the main body.

The "door" may seal the storage compartment in a closed state. The door may include an insulation, like the main body, to insulate the storage compartment in the closed state.

According to an embodiment, the door may include an outer door plate forming the front surface of the door, an inner door plate forming the rear surface of the door and facing the storage compartment, an upper cap, a lower cap, and a door insulation provided therein.

A gasket may be provided on the edge of the inner door plate to seal the storage compartment by coming into close contact with the front surface of the main body when the door is closed. The inner door plate may include a dyke that protrudes rearward to allow a door basket for storing items to be fitted.

According to an embodiment, the door may include a door body and a front panel that is detachably coupled to the front of the door body and forms the front surface of the door. The door body may include an outer door plate that forms the front surface of the door body, an inner door plate that forms the rear surface of the door body and faces the storage compartment, an upper cap, a lower cap, and a door insulator provided therein.

The refrigerator may be classified as French Door Type, Side-by-side Type, Bottom Mounted Freezer (BMF), Top Mounted Freezer (TMF), or One Door Refrigerator depending on the arrangement of the doors and the storage compartments.

The refrigerator according to an embodiment of the disclosure may include a cold air supply device for supplying cold air to the storage compartment.

The "cold air supply device" may include a machine, an apparatus, an electronic device, and/or a combination system thereof, capable of generating cold air and guiding the cool air to cool the storage compartment.

According to an embodiment of the disclosure, the cold air supply device may generate cold air through a cooling cycle including compression, condensation, expansion, and evaporation processes of refrigerants. To this end, the cold air supply device may include a cooling cycle device having a compressor, a condenser, an expander, and an evaporator to drive the cooling cycle. According to an embodiment of the disclosure, the cold air supply device may include a semiconductor such as a thermoelectric element. The thermoelectric element may cool the storage compartment by heating and cooling actions through the Peltier effect.

The refrigerator according to an embodiment of the disclosure may include a machine compartment where at least some components belonging to the cold air supply device are installed.

The "machine compartment" may be partitioned and insulated from the storage compartment to prevent heat generated from the components installed in the machine compartment from being transferred to the storage compartment. To dissipate heat from the components installed inside the machine compartment, the machine compartment may communicate with outside of the main body.

The refrigerator according to an embodiment of the disclosure may include a dispenser provided on the door to provide water and/or ice. The dispenser may be provided on the door to allow access by the user without opening the door.

The refrigerator according to an embodiment of the disclosure may include an ice-making device that produces ice. The ice-making device may include an ice-making tray that stores water, an ice-moving device that separates ice from the ice-making tray, and an ice-bucket that stores ice generated in the ice-making tray.

The refrigerator according to an embodiment of the disclosure may include a controller for controlling the refrigerator.

The "controller" may include a memory for storing and/or memorizing data and/or programs for controlling the refrigerator, and a processor for outputting control signals for controlling the cold air supply device, etc. according to the programs and/or data memorized in the memory.

The memory may store or record various information, data, commands, programs, and the like necessary for operations of the refrigerator. The memory may store temporary data generated while generating control signals for controlling components included in the refrigerator. The memory may include at least one of volatile memory or non-volatile memory, or a combination thereof.

The processor may control the overall operation of the refrigerator. The processor may control the components of the refrigerator by executing programs stored in memory. The processor may include a separate neural processing unit (NPU) that performs an operation of an artificial intelligence (AI) model. In addition, the processor may include a central processing unit (CPU), a graphics processor (GPU), and the like. The processor may generate a control signal to control the operation of the cold air supply device. For example, the processor may receive temperature information of the storage compartment from a temperature sensor, and generate a cooling control signal for controlling an operation of the cold air supply device based on the temperature information of the storage compartment.

Furthermore, the processor may process a user input of a user interface and control an operation of the user interface according to the programs and/or data memorized/stored in the memory. The user interface may be provided using an input interface and an output interface. The processor may receive the user input from the user interface. In addition, the processor may transmit a display control signal and image data for displaying an image on the user interface to the user interface in response to the user input.

The processor and memory may be provided integrally or may be provided separately. The processor may include one or more processors. For example, the processor may include a main processor and at least one sub-processor. The memory may include one or more memories.

The refrigerator according to an embodiment of the disclosure may include a processor and a memory for controlling all the components included in the refrigerator, and may include a plurality of processors and a plurality of memories for individually controlling the components of the refrigerator. For example, the refrigerator may include a processor and a memory for controlling the operation of the cold air supply device according to an output of the temperature sensor. In addition, the refrigerator may be separately equipped with a processor and a memory for controlling the operation of the user interface according to the user input.

A communication module may communicate with external devices, such as servers, mobile devices, and other home appliances via a nearby access point (AP). The AP may connect a local area network (LAN) to which a refrigerator or a user device is connected to a wide area network (WAN) to which a server is connected. The refrigerator or the user device may be connected to the server via the WAN.

The input interface may include keys, a touch screen, a microphone, and the like. The input interface may receive the user input and pass the received user input to the processor.

The output interface may include a display, a speaker, and the like. The output interface may output various notifications, messages, information, and the like generated by the processor.

Hereinafter, various embodiments according to the disclosure will be described in detail with reference to the accompanying drawings.

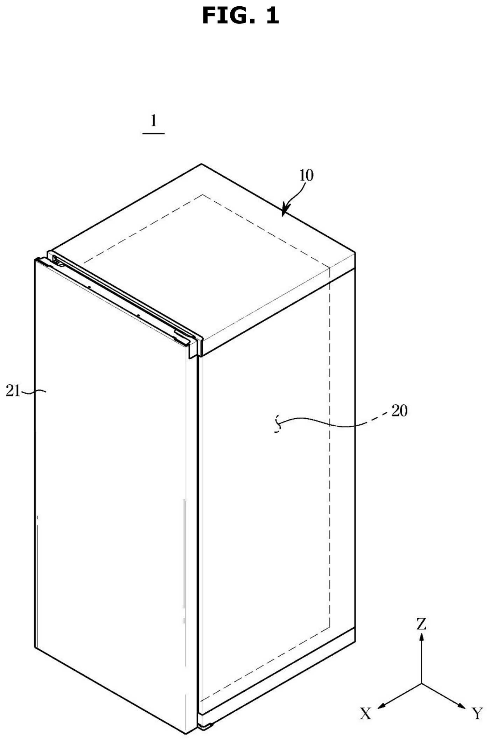

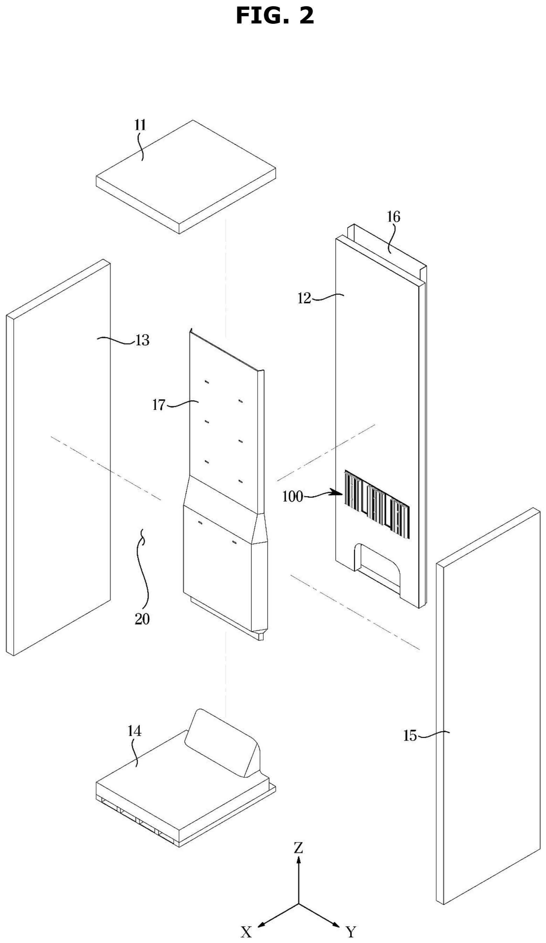

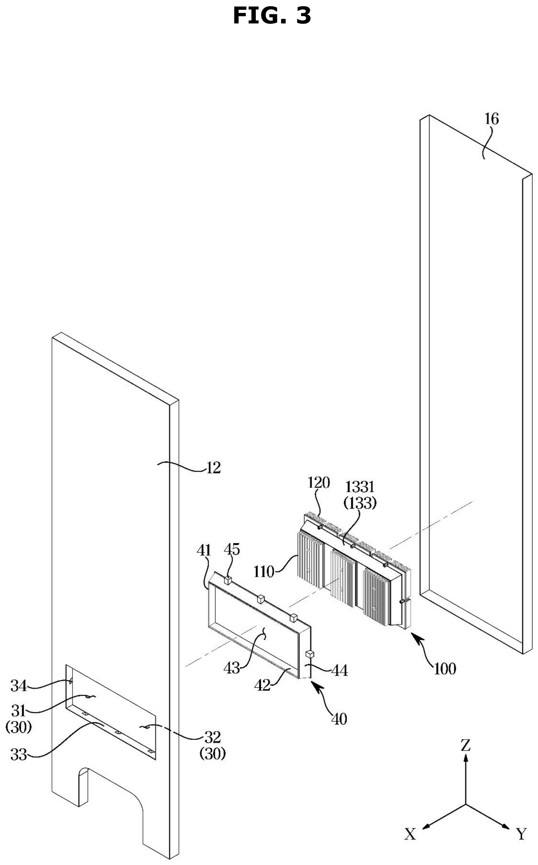

FIG. 1 is a view illustrating a refrigerator according to an embodiment. FIG. 2 is an exploded view illustrating a plurality of insulating walls of the refrigerator according to an embodiment. FIG. 3 is a view illustrating a module assembly and a module frame separated from the insulating walls, according to an embodiment.

Referring to FIGS. 1 to 3, a refrigerator 1 may include a main body 10 including a plurality of insulating walls 11, 12, 13, 14, and 15, and a storage compartment 20 formed in an interior of the main body 10, a door 21 provided to open or close the storage compartment 20, and a module assembly 100 including a thermoelectric module M configured to cool the storage compartment 20. The thermoelectric module M may include a plurality of thermoelectric modules Ma, Mb, and Mc (further description of the thermoelectric module M will be described later).

The plurality of insulating walls 11, 12, 13, 14, and 15 may be assembled together to form the main body 10. The plurality of insulating walls 11, 12, 13, 14, and 15 may be joined together by various known methods. For example, each of the plurality of insulating walls 11, 12, 13, 14, and 15 may include an uneven (e.g., concave-convex) structure, a hook structure, or the like that may be engaged with each other.

The plurality of insulating walls 11, 12, 13, 14, and 15 may include an upper (+Z side) insulating wall 11, a left (-Y side) insulating wall 13, and a right (+Y side) insulating wall 15, a lower (-Z side) insulating wall 14, and a rear (-X side) insulating wall 12. The upper insulating wall 11, the left insulating wall 13, the right insulating wall 15, the lower insulating wall 14, and the rear insulating wall 12 may be provided separately from each other and may be assembled together.

However, at least some of the upper insulating wall 11, the left insulating wall 13, the right insulating wall 15, the lower insulating wall 14, and the rear insulating wall 12 may be formed integrally.

In addition, all of the upper insulating wall 11, the left insulating wall 13, the right insulating wall 15, the lower insulating wall 14, and the rear insulating wall 12 may be formed integrally.

The storage compartment 20 may store items (e.g., food items). The storage compartment 20 may be formed to have an open front (+X direction) to allow items to be loaded or unloaded from the storage compartment 20.

A thermoelectric element 150a included in the module assembly 100 may cool the storage compartment 20 by means of the Peltier effect. The module thermoelectric assembly may be disposed in any one of the plurality of insulating walls 11, 12, 13, 14, and 15.

FIG. 2 shows an example in which the module assembly 100 is provided in the rear insulating wall 12 of the plurality of insulating walls 11, 12, 13, 14, and 15, but is not limited thereto. The module assembly 100 may be provided in other insulating walls to cool the storage compartment 20. Furthermore, although one module assembly 100 is shown in FIG. 2, the refrigerator 1 is not limited thereto and may include a plurality of module assemblies 100. For example, the module assembly 100 may be mounted on each of the insulating walls. In addition, a plurality of module assemblies may be mounted on any one of the plurality of insulating walls 11, 12, 13, 14, and 15.

The interior of each of the plurality of insulating walls 11, 12, 13, 14, and 15 may be filled with an insulation. The insulation may include urethane foam. A urethane foaming liquid may be foamed and cured to form urethane foam on each of an interior of the plurality of insulating walls 11, 12, 13, 14, and 15.

The storage compartment 20 may be thermally insulated from the outside O by the insulation filled in the plurality of insulating walls 11, 12, 13, 14, and 15.

The main body 10 may include a first rear panel 17 covering the rear insulating wall 12 from the front (+X direction), and a second rear panel 16 covering the rear insulating wall 12 from the rear (-X direction).

The first rear panel 17 may be mounted to the rear insulating wall 12 to cover one side of the rear insulating wall 12 facing the storage compartment 20. The first rear panel 17 may be mounted to one surface of the rear insulating wall 12 to cover the module assembly 100 from the front.

Although the first rear panel 17 is mounted to one surface of the rear insulating wall 12, the module assembly 100 may still be configured to communicate with the storage compartment 20. Accordingly, the module assembly 100 may exchange heat with the storage compartment 20.

The second rear panel 16 may be mounted to the rear insulating wall 12 to cover the other side of the rear insulating wall 12 facing an opposite side of the storage compartment 20. The second rear panel 16 may be mounted to the other surface of the rear insulating wall 12 to cover the module assembly 100 from the rear.

Hereinafter, the insulating wall on which the module assembly 100 is mounted will be shown and described as the rear insulating wall 12.

The refrigerator 1 may include a module frame 40 on which the module assembly 100 is mounted. The thermoelectric module M may be coupled to the module frame 40 and seated on the insulating wall 12.

The module frame 40 may be arranged to be secured to the insulating wall 12. In particular, the rear insulating wall 12 may include a hole 30, and the module frame 40 may be formed along an inner circumferential surface 33 of the hole. In other words, the module frame 40 may be coupled to the insulating wall such that an outer circumferential surface 44 of the module frame 40 is in contact with the inner circumferential surface 33 of the hole.

The urethane that fills the interior of the rear insulating wall 12, as described above, may be provided to fill an internal space of the rear insulating wall 12 formed by the rear insulating wall 12 and the module frame 40.

Since the module assembly 100 is coupled to the module frame 40, the thermoelectric module M may be inserted into the hole 30 and seated on the insulating wall.

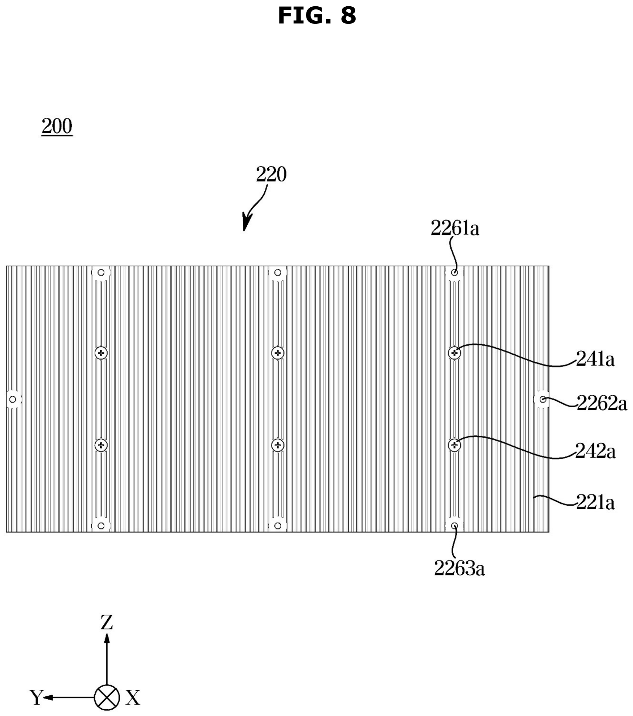

The module frame 40 may include fixing member coupling portions 45 that protrude radially along the outer circumferential surface 44 of the module frame 40. The fixing member coupling portions 45 may couple the module assembly 100 to the module frame 40 by coupling a fixing member 181a (e.g. a fastener) (see FIG. 8), which is included in the module assembly 100.

The hole 30 may include a first opening 31 facing the storage compartment 20 and a second opening 32 facing the opposite side of the storage compartment 20. As will be described later, a cooling sink 110 included in the thermoelectric module M may be provided to protrude into the storage compartment 20 through the first opening 31 and exchange heat with the storage compartment 20, and a heat sink 120 may be provided to protrude to the opposite side of the storage compartment 20 through the second opening 32 and exchange heat with the outside O.

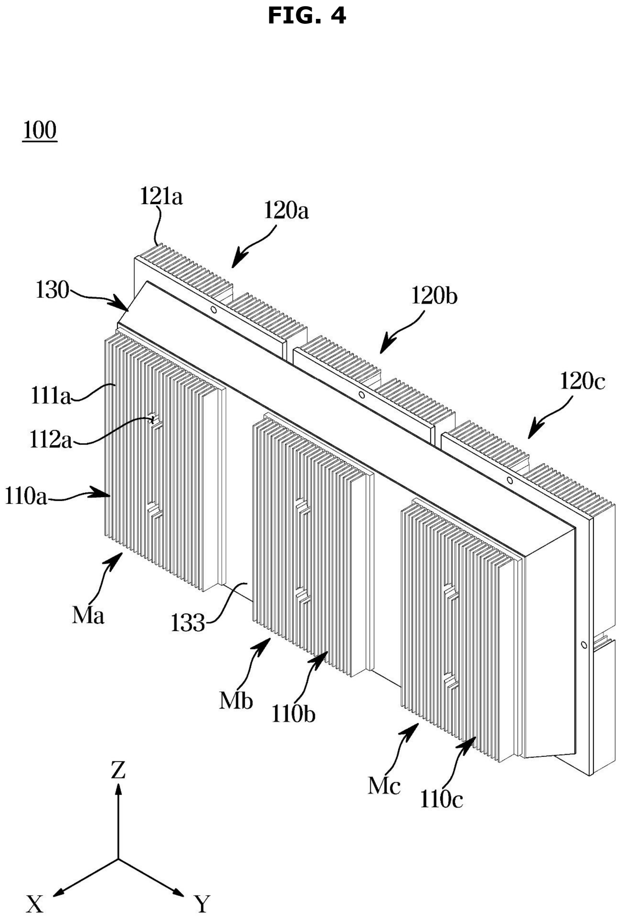

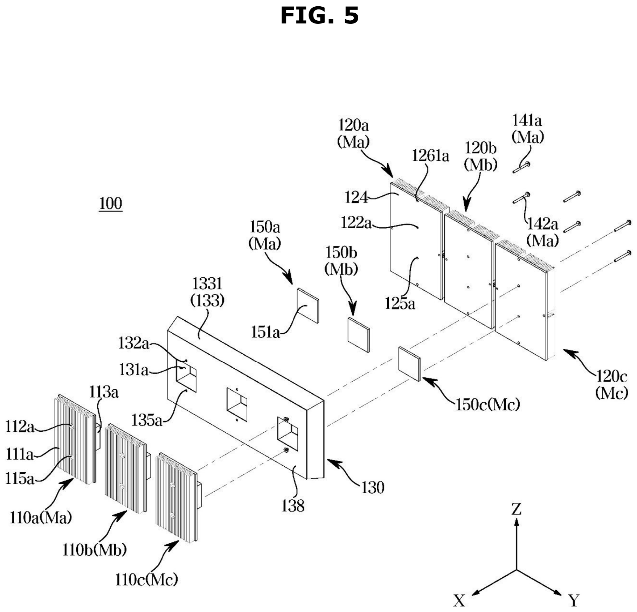

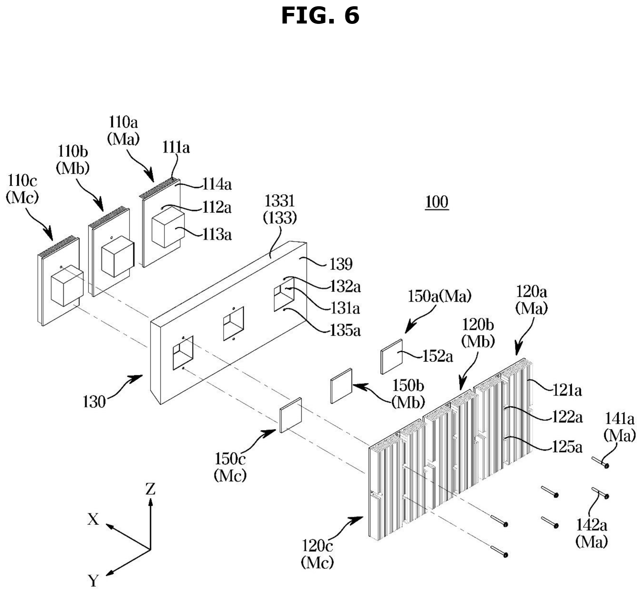

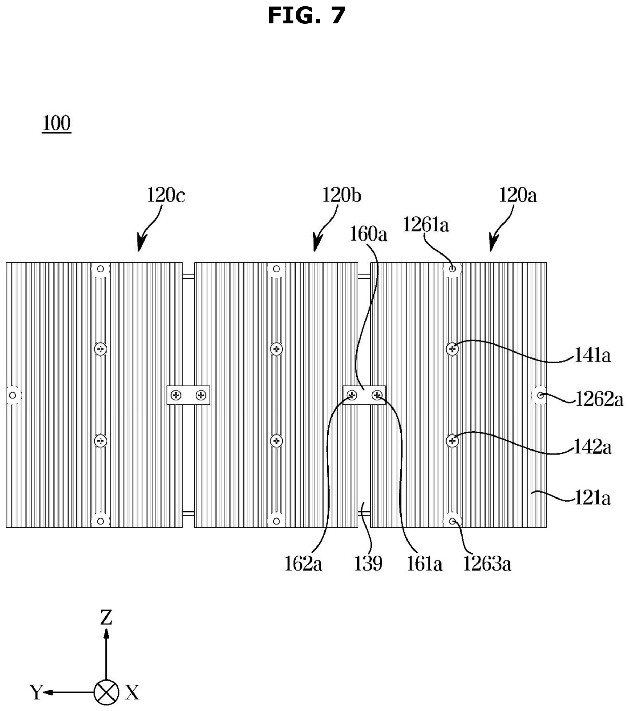

FIG. 4 is a view illustrating the module assembly according to an embodiment. FIG. 5 is a view illustrating the module assembly separated, according to an embodiment. FIG. 6 is a view of FIG. 5 from another angle. FIG. 7 is a view illustrating the module assembly according to an embodiment from the rear.

Referring to FIGS. 4 to 7, the module assembly 100 may include the thermoelectric module M. The thermoelectric module M may include the plurality of thermoelectric modules Ma, Mb, and Mc. In the following, the thermoelectric module will be described using one thermoelectric module Ma of the plurality of thermoelectric modules Ma, Mb, and Mc as an example.

The thermoelectric module Ma may include the thermoelectric element 150a configured to cool the storage compartment 20 by means of the Peltier effect, and a cooling sink 110a and a heat sink 120a configured to exchange heat with the thermoelectric element 150a. In addition, the thermoelectric module Ma may include a coupling member 141a (e.g., coupler, fastener) that couples the cooling sink 110a and the heat sink 120a to allow the cooling sink 110a and the heat sink 120a to be pressed against the thermoelectric element 150a. The coupling member 141a may be installed to penetrate the cooling sink 110a and the heat sink 120a, respectively. The coupling member 141a may be provided in a plurality.

The thermoelectric element 150a may include a heat-absorbing surface 151a formed on one surface facing the storage chamber 20 to absorb heat from the storage chamber 20. The thermoelectric element 150a may include a heat-generating surface 152a formed on an opposite side of one surface facing the storage compartment 20 to radiate heat absorbed by the heat-absorbing surface 151a. In other words, the heat in the storage compartment 20 may be discharged to the outside O through the thermoelectric element 150a, so that the storage compartment 20 may be cooled.

The cooling sink 110a may be in contact with the heat-absorbing surface 151a to exchange heat with the heat-absorbing surface 151a. In particular, the cooling sink 110a may include a cooling block 113a including one surface in direct contact with the heat-absorbing surface 151a, a cooling plate 114a attached to the other surface of the cooling block 113a, and cooling fins 111a protruding from the cooling plate 114a to face the storage compartment 20.

The cooling plate 114a may include a cooling sink coupling hole 112a through which the coupling member 141a penetrates.

The cooling sink coupling hole 112a may be formed through the cooling plate 114a. The cooling sink coupling hole 112a may be formed to penetrate the cooling plate 114a in a front-to-back direction (+-X direction).

The cooling sink coupling hole 112a may include a plurality of cooling sink coupling holes 112a and 115a. The plurality of cooling sink coupling holes 112a and 115a may be formed to be spaced apart from each other.

In an example, the plurality of cooling sink coupling holes 112a and 115a may be formed in the cooling plate 114a to be located at upper and lower sides with respect to the cooling block 113a, but the positions at which the plurality of cooling sink coupling holes 112a and 115a are formed may be varied.

The heat sink 120a may be in contact with the heat-generating surface 152a to exchange heat with the heat-generating surface 152a. In particular, the heat sink 120a may include a heating plate 124a including one surface in direct contact with the heat-generating surface 152a and heating fins 121a protruding from the heating plate 124a to face the opposite side of the storage compartment 20.

With the above arrangement, heat from the storage compartment 20 may move in the order of the cooling fins 111a, the cooling plate 114a, the cooling block 113a, the thermoelectric element 150a, the heating plate 124a, and the heating fins 121a and be discharged to the outside O.

The heating plate 124a may include a heat sink coupling hole 122a through which the coupling member 141a passes. The heat sink coupling hole 122a may be formed to penetrate the heating plate 124a. The heat sink coupling hole 122a may be formed to penetrate the heating plate 124a in the front-to-back direction (+-X direction).

The heat sink coupling hole 122a may include a plurality of heat sink coupling holes 122a and 125a. The plurality of heat sink coupling holes 122a and 125a may be formed to be spaced apart from each other.

The plurality of heat sink coupling holes 122a and 125a may be formed to correspond to the plurality of cooling sink coupling holes 112a and 115a. In other words, a spacing distance between the plurality of heat sink coupling holes 122a and 125a may correspond to the distance between the plurality of cooling sink coupling holes 112a and 115a.

The coupling member 141a may each penetrate both the cooling sink coupling hole 112a and the heat sink coupling hole 122a to couple the cooling sink 110a and the heat sink 120a. When the cooling sink 110a and the heat sink 120a are coupled, the thermoelectric element 150a may be disposed between the heat sink 120a and the cooling sink 110a. A detailed method in which the coupling member 141a couples the cooling sink 110a and the heat sink 120a will be described later.

The module assembly 100 may include a connector 160 that connects the plurality of thermoelectric modules Ma, Mb, and Mc together. For example, the connector 160 may be coupled with a plurality of heat sinks 120a, 120b, and 120c to interconnect the plurality of thermoelectric modules Ma, Mb, and Mc. In the following, the connector 160 will be described based on the connector 160a, which connects any two (e.g., Ma and Mb) thermoelectric modules of the plurality of thermoelectric modules.

In an example, the connector 160a may be coupled to a plurality of heating plates 124a and 124b included in the plurality of heat sinks 120a and 120b, respectively. For example, the connector 160a may be coupled at one end to a connecting portion 161a formed in one of the plurality of heat sinks 120a, and at the other end to a connecting portion 162a formed in another one of the plurality of heat sinks 120b.

In an example, the connector 160a may include a material, such as steel or titanium, to enable the plurality of thermoelectric modules Ma and Mb to be more firmly connected. As a result, the rigidity of the module assembly 100 as a whole may be further increased.

In an example, the connector 160a may be coupled to one surface of the heat sinks 120a and 120b facing the opposite side (-X side) of the storage compartment 20 to connect the plurality of thermoelectric modules Ma and Mb. Accordingly, when a user desires to separate only one thermoelectric module (e.g., Ma) of the plurality of thermoelectric modules Ma and Mb for maintenance and repair of the thermoelectric module Ma, only the rear insulating wall 12 may be removed to access the connector 160a. Thus, the user may more easily remove the connector 160a to perform maintenance and management of the thermoelectric module Ma.

Although not shown in the drawings, in an example, the connector 160 may be coupled with a plurality of cooling sinks 110a, 110b, and 110c to interconnect the plurality of thermoelectric modules Ma, Mb, and Mc. In such a case, the plurality of cooling sinks 110a, 110b, and 110c may be connected in the same manner as the plurality of heat sinks 120a, 120b, and 120c described above.

The module assembly 100 may include an insulation 130 disposed between the cooling sink 110 and the heat sink 120 to prevent and/or reduce heat loss from the cooling fins 111 to the heating fins 121. In the following, the insulation 130 will be described based on one thermoelectric module Ma of the plurality of thermoelectric modules Ma, Mb, and Mc.

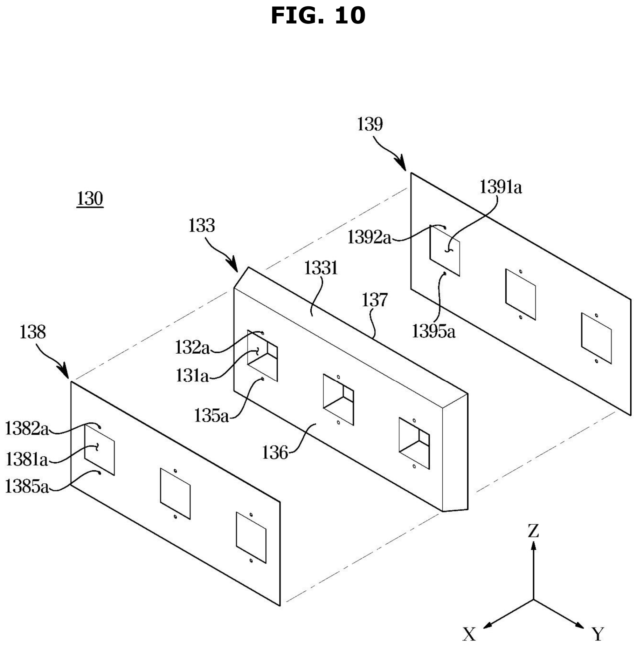

The insulation 130 may include an insulation body 133 that forms an exterior. The insulation 130 may include a first insulation surface 136 (see FIG. 10) facing the cooling sink 110a and a second insulation surface 137 (see FIG. 10) facing the heat sink 120a. The first insulation surface 136 may be formed on a front side of the insulation body 133, and the second insulation surface 137 may be formed on a rear side of the insulation body 133.

An outer circumferential surface 1331 of the insulation may be formed to extend from an outer circumference of the second insulation surface 137 toward an outer circumference of the first insulation surface 136. The first insulation surface 136 may be formed to have a smaller area than the second insulation surface 137, such that the outer circumferential surface 1331 of the insulation may have a cross-sectional area that narrows as it goes from the second insulation surface 137 toward the first insulation surface 136.

The insulation 130 may include a through hole 131 formed at a central portion of the insulation body 133. Based on the insulation 130 being disposed between the cooling sink 110a and the heat sink 120a, the cooling block 113a and the thermoelectric element 150a may be arranged to be inserted into the through hole 131a.

In other words, the insulation 130 may be configured to cover an edge portion of the cooling block 113a and the thermoelectric element 150a. Accordingly, heat moving from the cooling block 113a and the thermoelectric element 150a may travel to the heat sink 120a without leaking.

In an example, the through hole 131a may include a plurality of through holes 131a, 131b, and 131c. Based on the insulation 130 being disposed between the plurality of thermoelectric modules Ma, Mb, and Mc, the plurality of cooling blocks 113a, 113b, and 113c and the plurality of thermoelectric elements 150a, 150b, and 150c included in each of the plurality of modules Ma, Mb, and Mc may be inserted into the plurality of through holes 131a, 131b, and 131c, respectively.

The insulation 130 may include an insulation coupling hole 132. The insulation coupling hole 132 may be formed to penetrate the insulation body 133 in the front-to-back direction. Based on the insulation 130 being disposed between the cooling sink 110a and the heat sink 120a, the coupling member 141a may be arranged to penetrate an insulation coupling hole 132a.

The insulation coupling hole 132a may be arranged in a straight line with the cooling sink coupling hole 112a and the heat sink coupling hole 122a in the front-to-back direction (+-X direction). As a result, the coupling member 141a may be arranged to penetrate the cooling sink coupling hole 112a, the insulation coupling hole 132a, and the heat sink coupling hole 122a.

The insulation coupling hole 132a may include the plurality of insulation coupling holes 132a and 135a. For example, the plurality of insulation coupling holes 132a and 135a may be disposed upwardly and downwardly relative to the through hole 131a, respectively.

FIG. 8 is a view illustrating a module assembly according to an embodiment from the rear. Duplicative description of the above will be omitted herein.

Referring to FIG. 8, a module assembly 200 may include one heat sink 220 formed integrally. For example, the plurality of cooling sinks 110a, 110b, and 110c may each be coupled to one heat sink 220. By coupling each of the cooling sinks 110a, 110b, and 110c to the one heat sink 220 formed integrally, the rigidity of the module assembly 200 may be ensured even with a simplified structure.

In an example, the plurality of cooling sinks 110a, 110b, and 110c may be equally spaced apart from each other and coupled to the single heat sink 220.

In the following, the formation process of the module assembly 200 will be described based on one cooling sink 110a of the plurality of cooling sinks 110a, 110b, and 110c.

The cooling sink 110a and the heat sink 220 may be coupled by coupling members 241a and 242a.

The coupling members 241a and 242a are configured to penetrate the heat sink 220 and the cooling sink 110a, respectively, to interconnect the heat sink 220 and the cooling sink 110a.

The coupling members 241a and 242a may be disposed on upper and lower sides of one surface 221a of the heat sink 220, respectively. For example, the upper and lower sides of one surface 221a of the heat sink 220 through which the coupling members 241a and 242a penetrate may be points that are symmetrical to each other with respect to a center line in a horizontal direction (+-Y direction) of the heat sink 220, respectively. A distance by which the coupling members 241a and 242a are spaced apart from the center line may be varied.

On the one surface 221a of the heat sink 220 adjacent to an edge portion of the heat sink 220, a fixing hole 226 formed to penetrate the heat sink 220 may be provided. The fixing hole 226 may include a plurality of fixing holes 2261a, 2262a, and 2263a. For example, the plurality of fixing holes 2261a, 2262a, and 2263a may be formed on one surface 221a of the heat sink 220 along the edge of the heat sink 220 at equal intervals.

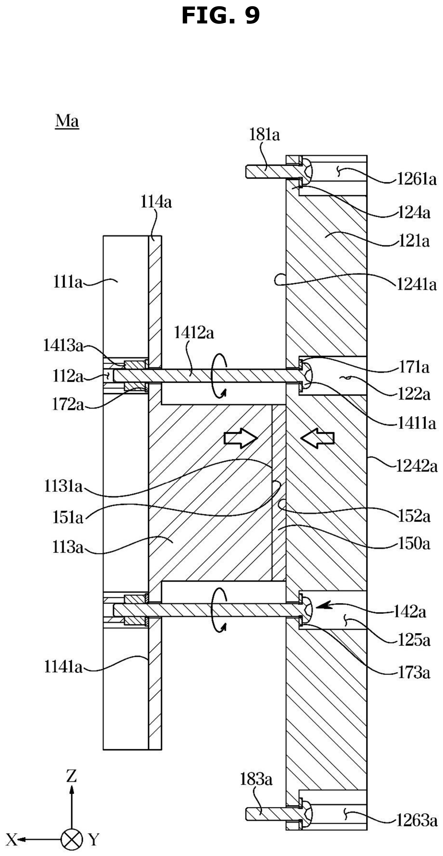

The fixing holes 226 may each be penetrated by the fixing member 181a (see FIG. 9). The fixing member 181a may be arranged to pass through the fixing hole 226 and be coupled to the module frame 40. As a result, by means of the fixing holes 226 formed in the heat sink 220, the module assembly 200 may be supported by the heat sink 220 and mounted to the module frame 40.

FIG. 9 is a side cross-sectional view of the thermoelectric module according to an embodiment.

Hereinafter, the manner in which the cooling sink 110a, the thermoelectric element 150a, and the heat sink 120a are coupled to each other by the coupling member 141a, based on one thermoelectric module Ma of the plurality of thermoelectric modules will be described in detail.

Referring to FIG. 9, the coupling member 141a may include a first coupling portion 1412a that passes through the cooling sink coupling hole 112a and the heat sink coupling hole 122a to connect the cooling sink 110a and the heat sink 120a. For example, the first coupling portion 1412a may include a bolt body in the shape of extending in the front-back direction (+-X direction) and including threads.

The first coupling portion 1412a may be positioned on an upper side of the thermoelectric element 150a and the cooling block 113a. Accordingly, heat flowing through the cooling block 113a and the thermoelectric element 150a may not escape to the coupling member 141a side.

The coupling member 141a may include a second coupling portion 1413a connected to one end of the first coupling portion 1412a. For example, the second coupling portion 1413a may be provided to be supported on one surface 1141a of the cooling sink 110a facing the storage compartment 20. For example, the second coupling portion 1413a may include a nut. When the second coupling portion 1413a is provided as a nut, it may be movable on the first coupling portion 1412a by engaging with the threads of the first coupling portion 1412a.

The coupling member 141a may include a third coupling portion 1411a connected to the other end of the first coupling portion 1412a. For example, the third coupling portion 1411a may include a bolt head formed at the other end of the first coupling portion 1412a. The third coupling portion 1411a may be provided to be supported on one surface 1242a of the heat sink 120a facing the opposite side of the storage compartment 20.

In an example, the first coupling portion 1412a and the third coupling portion 1411a may be formed integrally. When the third coupling portion 14111a rotates, the first coupling portion 1412a may rotate.

When the first coupling portion 1412a rotates, the second coupling portion 1413a may move rearward (-X direction) in engagement with the threads of the first coupling portion 1412a. In other words, the second coupling portion 1413a may press one surface of the cooling sink 110a supporting the second coupling portion 1413a in the rearward (-X direction).

The third coupling portion 1411a may be moved forward (+X direction) by rotation. In other words, the third coupling portion 1411a may press one surface of the heat sink 120a supporting the third coupling portion 1411a in the forward (+X direction).

At this time, since the thermoelectric element 150a is disposed between the cooling sink 110a and the heat sink 120a, the thermoelectric element 150a may be pressed by the cooling sink 110a and the heat sink 120a in response to the rotation of the first coupling portion 1412a.

In other words, the thermoelectric element 150a may be pressed rearward (-X direction) by the cooling block 113a and forward (+X direction) by the heat plate. As a result, the thermoelectric element 150a may be effectively fixed between the cooling sink 110a and the heat sink 120a.

With the above structure of the coupling member 141a, the cooling sink 110a, the heat sink 120a, and the thermoelectric element 150a may not require a separate coupling frame for coupling. Thus, the thermoelectric module Ma may be made lighter.

The thermoelectric module Ma may include a first cover 172a disposed on one surface 1141a of the cooling sink 110a to cover an outer circumference of the cooling sink coupling hole 112a. In particular, the first cover 172a may be disposed to cover the outer circumference of the cooling sink coupling hole 112a on one surface 1141a of the cooling plate 114a facing the storage compartment 20.

The second coupling portion 1413a may be arranged to contact the first cover 172a. As a result, the second coupling portion 1413a may be supported on the cooling sink 110a through the first cover 172a.

The first cover 172a may include an insulating material. Accordingly, the cooling sink 110a may effectively prevent and/or reduce heat from flowing toward the storage compartment 20 through the cooling sink coupling hole 112a.

The thermoelectric module Ma may include a second cover 171a disposed on one surface 1242a of the heat sink 120a to cover an outer circumference of the heat sink coupling hole 122a. In particular, the second cover 171a may be arranged to cover the outer circumference of the heat sink coupling hole 122a on one surface 1242a of the heating plate 124a facing away from the storage compartment 20.

The third coupling portion 1411a may be arranged to contact the second cover 171a. As a result, the third coupling portion 1411a may be supported on the heat sink 120a through the second cover 171a.

The second cover 171a may include an insulating material. Accordingly, the heat sink 120a may effectively prevent and/or reduce heat from the outside O from flowing to the storage compartment 20 side through the heat sink coupling hole 122a.

The coupling member 141 may include the plurality of coupling members 141a and 142a, and each of the coupling members 141a and 142a may be arranged to be disposed above and below the thermoelectric element 150a, respectively. However, this is only an example, and the plurality of coupling members 141a and 142a may be arranged in a variety of ways.

In the above, the second coupling portion 1413a is described as being disposed on the cooling sink 110a side and being the nut, and the third coupling portion 1411a is described as being disposed on the heat sink 120a side and being the bolt head. However, this is by way of example only, and it should be understood that it is also possible for the second coupling portion 1413a to be a bolt head and the third coupling portion 1411a to be a nut.

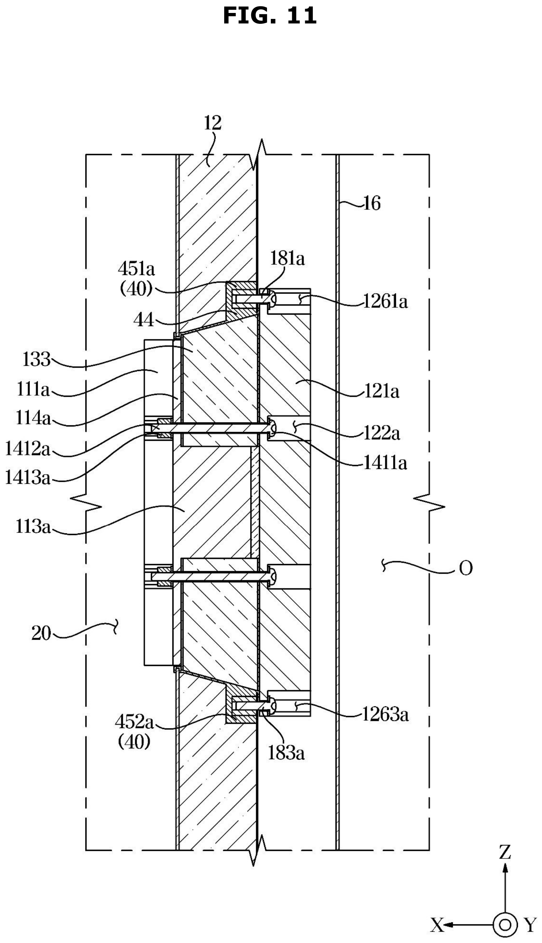

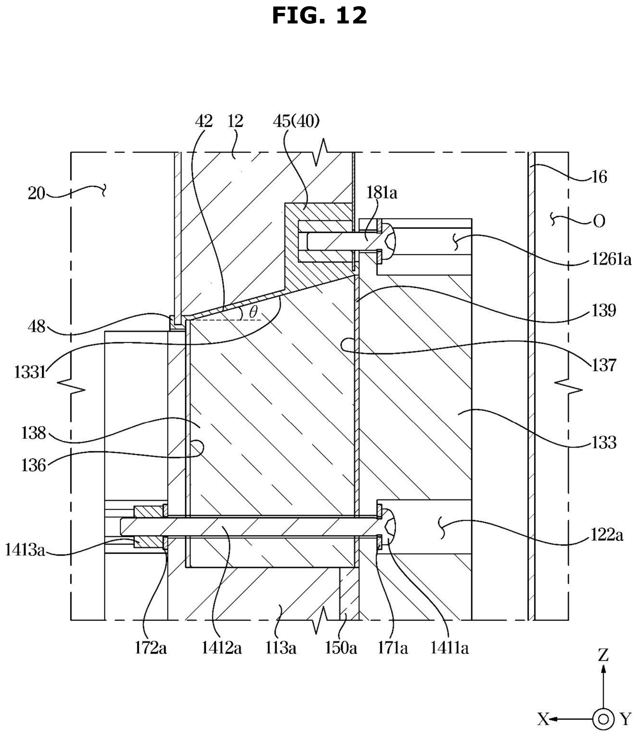

FIG. 10 is an exploded view illustrating the insulation according to an embodiment. FIG. 11 is a side cross-sectional view illustrating the rear insulating wall. FIG. 12 is an enlarged view illustrating a portion of the side cross-section of the rear insulating wall according to an embodiment.

Referring to FIGS. 10 to 12, the insulation 130 may include a urethane material. The insulation 130 may include a first cover plate 138 covering the first insulation surface 136 facing the cooling sink 110a. The insulation 130 may include a second cover plate 139 covering the second insulation surface 137 facing the heat sink 120a.

The first cover plate 138 may cover the first insulation surface 136 of the insulation 130 facing the storage compartment 20 to protect the first insulation surface 136 from moisture and the like in the storage compartment 20. Accordingly, damage to the insulation 130 including the urethane material may be prevented.

The first cover plate 138 may be in contact with one surface of the cooling sink 110a facing the insulation 130. In particular, one surface of the cooling plate 114a facing the insulation 130 may be arranged to be in contact with one surface of the first cover plate 138 facing the storage compartment 20.

The first cover plate 138 may include a first cover plate through hole 1381 communicating with the through hole 131. As a result, the cooling block 113 and the thermoelectric element 150 may pass through the first cover plate through hole 1381 and be seated within the through hole 131.

The first cover plate 138 may include a first cover plate coupling hole 1382 through which the coupling member 141 passes. Accordingly, when the insulation 130 is disposed between the cooling sink 110 and the heat sink 120, the coupling member 141 may be arranged to penetrate the first cover plate coupling hole 1382. The first cover plate coupling hole 1382 may include a plurality of first cover plate coupling holes 1382 and 1385.

The second cover plate 139 may cover the second insulation surface 137 of the insulation 130 facing the outside O, thereby protecting the second insulation surface 137 from moisture, foreign substances, and the like from the outside O. Accordingly, damaged to the insulation 130 including the urethane material may be prevented.

The second cover plate 139 may be arranged to contact one surface of the heat sink 120a facing the insulation 130. In particular, one surface of the heating plate 124a facing the insulation 130 may be arranged to contact one surface of the second cover plate 139 facing away from the storage compartment 20.

The second cover plate 139 may include a second cover plate through hole 1391 communicating with the through hole 131. As a result, the thermoelectric element 150 may be arranged to contact the heat sink 120 through the second cover plate through hole 1391.

The second cover plate 139 may include a second cover plate coupling hole 1392 through which the coupling member 141 passes. Accordingly, when the insulation 130 is disposed between the cooling sink 110 and the heat sink 120, the coupling member 141 may be arranged to penetrate the second cover plate coupling hole 1392. The second cover plate coupling hole 1392 may include a plurality of second cover plate coupling holes 1392.

The module frame 40 may be formed along the inner circumferential surface 33 of the hole in the insulating wall and secured to the insulating wall 12.

The module frame 40 may be disposed such that the fixing member coupling portion 45 is located inside the insulating wall 12. Thereafter, in response to urethane being foamed on the inside of the insulating wall 12 and then cured, the fixing member coupling portion 45 may be secured to the inside of the insulating wall 12 by the cured urethane. As a result, the module frame 40 may be secured to the insulating wall 12.

The module frame 40 may include a front support 48 provided to support the front (+X direction) of the module assembly 100 when the module assembly 100 is coupled to the module frame 40.

The front support 48 may be formed on the front (+X direction) side of an inner circumferential surface 42 of the module frame 40 and may be formed to protrude downwardly (-Z direction). When the module assembly 100 is mounted to the module frame 40, a front surface of the first cover plate 138 of the insulation 130 may be supported on the front support 48. As a result, the module assembly 100 may be more stably seated on the module frame 40.

When the module assembly 100 is coupled to the module frame 40, the outer circumferential surface 1331 of the insulation may be arranged to contact the inner circumferential surface 42 of the module frame 40. Accordingly, the inner circumferential surface 42 of the module frame 40 and the outer circumferential surface 1331 of the insulation may include a shape corresponding to each other.

As described above, since the area of the first insulation surface 136 of the insulation 130 is arranged to be smaller than the area of the second insulation surface 137, the outer circumferential surface 1331 of the insulation extending from the outer circumference of the second insulation surface 127 to the outer circumference of the first insulation surface 136 may include a shape inclined by a certain angle θ toward the front (+X direction).

As described above, since the outer circumferential surface 1331 of the insulation includes a shape inclined by the certain angle θ toward the front (+X direction), thereby allowing the module assembly 100 to be more stably seated on the module frame 40 when in contact with the inner circumferential surface 42 of the module frame 40.

After the module assembly 100 is seated on the module frame 40, the fixing member 181a may couple the module assembly 100 and the module frame 40.

The fixing member 181a may be inserted through a fixing hole 1261a formed in the heat sink 120a. The fixing hole 1261a may be formed to penetrate the heat sink 120a. The fixing member 181a inserted into the fixing hole 1261a may be arranged to support one surface 1242a of the heat sink 120a in the forward (+X direction).

In an example, the fixing holes 1261a and 1263a may be formed at both upper and lower ends of the heat sink 120a, respectively.

The fixing member 181a inserted into the fixing hole 1261a may be coupled to the fixing member coupling portion 45 formed on the module frame 40. This may allow the module assembly 100 to be coupled to the module frame 40.

In an example, the fixing member 181a may include a screw, and the fixing member coupling portion 45 may include a tap hole into which the screw is inserted. However, this is by way of example only and the fixing member 181a and the fixing member coupling portion 45 may be coupled in a variety of ways.

Based on the module assembly 100 being coupled to the module frame 40, the cooling sink 110a may be positioned on the storage compartment 20 side. In particular, the cooling plate 114a may be disposed on the first opening 31 (see FIG. 2) of the hole 30 adjacent to the storage compartment 20. The cooling fins 111a may protrude from the cooling plate 114a toward the storage compartment 20. The cooling block 113a may protrude from the cooling plate 114a to face the opposite side of the storage compartment 20.

In addition, one end of the cooling block 113a facing the opposite side of the storage compartment 20 may be disposed to contact the thermoelectric element 150a. In particular, the one end of the cooling block 113a may be in contact with the heat-absorbing surface 151a of the thermoelectric element 150a. As a result, the heat-absorbing surface 151a may be disposed to face the storage compartment 20.

Based on the module assembly 100 being coupled to the module frame 40, the cooling block 113a and the thermoelectric element 150a may be positioned inside the hole 30. As a result, the thermoelectric element 150a may be positioned closer to the second opening 32, which is open to one side away from the storage compartment 20 than to the first opening 31, which is open to the other side toward the storage compartment 20. The reason why the thermoelectric element 150a is disposed adjacent to the second opening 32 is because the heat generation amount of the thermoelectric element 150a is higher than the heat absorption amount, so that it is advantageous for heat dissipation for the thermoelectric element 150a to be adjacent to the second opening 32 through which heat is dissipated.

Based on the module assembly 100 being coupled to the module frame 40, the heat sink 120a may be arranged to contact the heat-generating surface 152a formed on the opposite side of the heat-absorbing surface 151a. In particular, one surface of the heating plate 124a may be disposed to contact the heat-generating surface 152a, and the heating fins 121a may protrude from the other surface of the heating plate 124a to face the opposite side of the storage compartment 20. The heating plate 124a may be disposed on the second opening 32 (see FIG. 2) of the hole 30 adjacent to the outside O.

The insulation 130 may be disposed between the cooling plate 114a and the heating plate 124a to surround the outer edges of the cooling block 113a and the thermoelectric element 150a. The outer circumferential surface 1331 of the insulation may be disposed to be in contact with the inner circumferential surface 42 of the module frame 40, thereby enabling the module assembly 100 to be stably seated on the module frame 40.

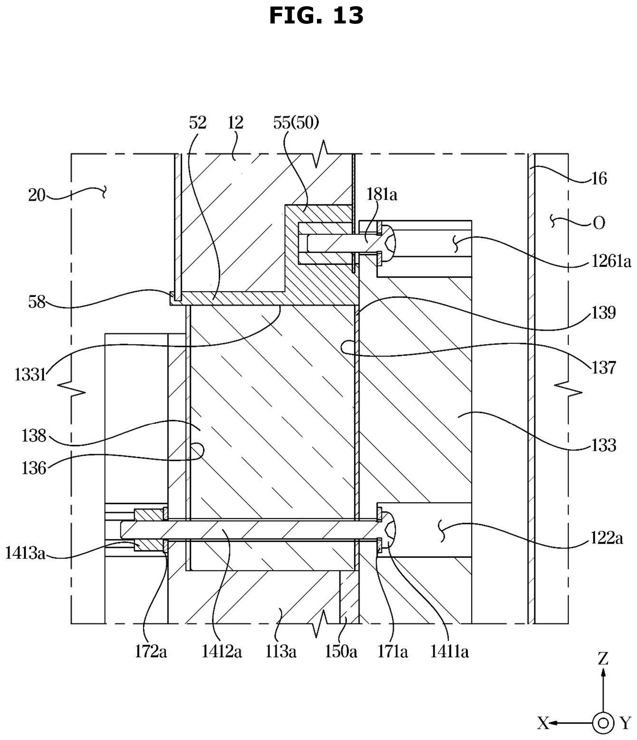

FIG. 13 is an enlarged view of a portion of the side cross-section of the rear insulating wall according to an embodiment. Duplicative description of the above will be omitted herein.

Referring to FIG. 13, based on the module assembly 100 being coupled to the module frame 40, an outer circumferential surface 2331 of the insulation may be arranged to contact an inner circumferential surface 52 of a module frame 50. As a result, the inner circumferential surface 52 of the module frame 50 and the outer circumferential surface 2331 of the insulation may include a shape corresponding to each other.

In an example, the area of a first insulation surface 236 of an insulation 230 may be provided to be the same as the area of a second insulation surface 237. For example, the area of the first insulation surface 236 or the second insulation surface 237 may be provided to be larger than the area of the cooling sink 110.

The outer circumferential surface 2331 of the insulation extending from the outer circumference of the second insulation surface 237 to the outer circumference of the first insulation surface 236 may extend in a direction parallel to the front-back direction (+-X direction).

The refrigerator 1 according to an embodiment may include the main body 10 including the insulating wall 12 in which the hole 30 is formed. The refrigerator 1 may include the storage compartment 20 formed inside the main body 10. The refrigerator 1 may include thermoelectric module Ma inserted into the hole 30 to be seated on the insulating wall 12, and configured to cool the storage compartment 20. The thermoelectric module Ma may include the thermoelectric element 150a including the heat-absorbing surface 151a formed on one surface facing the storage compartment20 to absorb heat from the storage compartment 20 and the heat-generating surface 152a formed on the opposite side to radiate the heat absorbed by the heat-absorbing surface 151a. The thermoelectric module Ma may include the cooling sink 110a in contact with the heat-absorbing surface 151a to exchange heat with the heat-absorbing surface 151a. The thermoelectric module Ma may include the heat sink 120a in contact with the heat-generating surface 152a to exchange heat with the heat-generating surface 152a. The thermoelectric module Ma may include the coupling member 141a configured to couple the cooling sink 110a and the heat sink 120a to allow the cooling sink 110a and the heat sink 120a to be respectively pressed against the thermoelectric element 150a.

The cooling sink 110a and the heat sink 120a may each include the coupling hole 30 through which the coupling member 141a passes. The coupling member 141a may include the first coupling portion 1412a that passes through the coupling hole 30 to connect the cooling sink 110a and the heat sink 120a. The coupling member 141a may include the second coupling portion 1413a connected to one end of the first coupling portion 1412a and configured to be supported on one side of the cooling sink 110a facing the storage compartment 20. The coupling member 141a may include the third coupling portion 1411a connected to the other end of the first coupling portion 1412a and configured to be supported on one surface 1242a of the heat sink 120a facing the opposite side of the storage compartment 20. The second coupling portion 1413a or the third coupling portion 1411a may be configured to be movable toward the thermoelectric element 150a.

The first coupling portion 1412a may include a bolt body. The second coupling portion 1413a may include a nut. The third coupling portion 1411a may include a bolt head.

The refrigerator 1 may further include the module frame 40 formed along the inner circumferential surface 33 of the hole and be secured to the insulating wall 12. The thermoelectric module Ma may be coupled to the module frame 40 and seated on the insulating wall 12.

The thermoelectric module Ma may include the plurality of thermoelectric modules Ma, Mb, and Mc. The refrigerator 1 may further include the connector 160 that connects the plurality of thermoelectric modules Ma, Mb, and Mc to each other.

The plurality of thermoelectric modules Ma, Mb, and Mc may include the plurality of heat sinks 120a, 120b, and 120c. The connector 160 may be configured to interconnect the plurality of thermoelectric modules Ma, Mb, and Mc by coupling the plurality of heat sinks 120a, 120b, and 120c.

The connector 160a may be coupled to one sides of the plurality of heat sinks 120a facing away from the storage compartment 20 to connect the plurality of thermoelectric modules Ma, Mb, and Mc.

The refrigerator 1 may further include the insulation 130 including the through hole 131a into which the thermoelectric element 150a is inserted. The insulation 130 may be disposed between the cooling sink 110a and the heat sink 120a.

The insulation 130 may include the first cover plate 138 that covers the first insulation surface 136 facing the cooling sink 110a. The insulation 130 may include the second cover plate 139 that covers the second insulation surface 137 facing the heat sink 120a. The first cover plate 138 may be configured to contact one surface of the cooling sink 110a facing the insulation 130. The second cover plate 139 may be configured to contact one surface of the heat sink 120a facing the insulation 130.

Based on the thermoelectric module Ma being coupled to the module frame 40, the outer circumferential surface 1331 of the insulation may be configured to contact the inner circumferential surface 42 of the module frame 40.

The insulation 130 may include the first insulation surface 136 facing the cooling sink 110a, the first insulation surface 136 having a smaller cross-sectional area than the second insulation surface 137 facing the heat sink 120a. The outer circumferential surface 1331 of the insulation may extend at an angle from the outer circumference of the second insulation surface 137 toward the outer circumference of the first insulation surface 136. The inner circumferential surface 42 of the module frame 40 may include a shape corresponding to the outer circumferential surface 1331 of the insulation and may be disposed to be contact with the outer circumferential surface 1331 of the insulation.

The cooling sink 110a may include the cooling plate 114a configured to contact the first cover plate 138, and the cooling block 113a protruding from the cooling plate 114a to be inserted into the through hole 131a. The heat sink 120a may include the heating plate 124a configured to contact the second cover plate 139. The thermoelectric element 150a may be arranged such that the heat-absorbing surface 151a is in contact with the cooling block 113a and the heat-generating surface 152a is in contact with the heating plate 124a.

The hole 30 may include the inner opening 31 that is open to one side toward the storage compartment 20 and the outer opening 32 that is open to the opposite side. The thermoelectric element 150a may be disposed closer to the outer opening 32 than the inner opening 31.

The heat sink 120a may be configured to be secured to the module frame 40 to allow the thermoelectric module Ma to be coupled to the module frame 40.

The cooling sink 110a and the heat sink 120a may each include the coupling hole 30 through which the coupling member 141a passes. The thermoelectric module Ma may include the first cover 172a that covers the outer circumference of the coupling hole 30 of the cooling sink 110a formed on one surface 1141a of the cooling sink 110a. The thermoelectric module Ma may include the second cover 171a that covers the outer circumference of the coupling hole 30 of the heat sink 120a formed on one surface 1242a of the heat sink 120a. The first cover 172a and the second cover 171a may include an insulating material.

The refrigerator 1 according to an embodiment includes the main body 10 including the plurality of insulating walls 11, 12, 13, 14, and 15. The refrigerator 1 may include the storage compartment 20 formed within the main body 10. The refrigerator 1 may include the plurality of thermoelectric modules Ma, Mb, and Mc seated on any one of the plurality of insulating walls 11, 12, 13, 14, and 15, the plurality of thermoelectric modules Ma, Mb, and Mc inserted into the hole 30 and configured to cool the storage compartment 20. Each of the plurality of thermoelectric modules Ma, Mb, and Mc may include the thermoelectric element 150 including the heat-absorbing surface 151 formed on one side facing the storage compartment 20 to absorb heat from the storage compartment 20 and the heat-generating surface 152 formed on the opposite side to emit the heat absorbed by the heat-absorbing surface 151. Each of the plurality of thermoelectric modules Ma, Mb, and Mc may include the cooling sink 110 in contact with the heat-absorbing surface 151 to exchange heat with the heat-absorbing surface 151. Each of the plurality of thermoelectric modules Ma, Mb, and Mc may include the heat sink 120 in contact with the heat-generating surface 152 to exchange heat with the heat-generating surface 152. Each of the plurality of thermoelectric modules Ma, Mb, and Mc may include the coupling member 141 configured to couple the cooling sink 110 and the heat sink 120 to allow the cooling sink 110 and the heat sink 120 to be respectively pressed against the thermoelectric element 150 side.

The refrigerator 1 may further include the connector 160 configured to connect the plurality of thermoelectric modules Ma, Mb, and Mc to each other. The connector 160 may be configured to connect the plurality of thermoelectric modules Ma, Mb, and Mc by coupling toe plurality of heat sinks 120 included in each of the plurality of thermoelectric modules Ma, Mb, and Mc.

The cooling sink 110 and the heat sink 120 may each include the coupling hole 30 through which the coupling member 140 passes. The coupling member 141 may include the first coupling portion 1412 that passes through the coupling hole 30 to connect the cooling sink 110 and the heat sink 120. The coupling member 141 may include the second coupling portion 1413 connected to one end of the first coupling portion 1412 and configured to be supported on one side of the cooling sink 110 facing the storage compartment 20. The coupling member 141 may include the third coupling portion 1411 connected to the other end of the first coupling portion 1412 and configured to be supported on one surface of the heat sink 120 facing the opposite side of the storage compartment 20. The second coupling portion 1413 or the third coupling portion 1411 may be configured to be movable toward the thermoelectric element 150.

The refrigerator 1 may include the module frame 40 formed along the inner circumferential surface 33 of the hole and be secured to the insulating wall 12, the module frame 40 coupled to the thermoelectric module Ma to allow the thermoelectric module Ma to be seated on the insulating wall 12. The refrigerator 1 may further include the insulation 130 disposed between the cooling sink 110 and the heat sink 120, the insulation 130 including the through hole 131 into which the thermoelectric element 150 is inserted. Based on the thermoelectric module M being coupled to the module frame 40, the outer circumferential surface 1331 of the insulation may be disposed to contact the inner circumferential surface 42 of the module frame 40.

The insulation 130 may be formed such that the first insulation surface 136 facing each of the cooling sinks 110 has a smaller cross-sectional area than the second insulation surface 137 facing each of the heat sinks 120. The outer circumferential surface 1331 of the insulation may extend at an angle from the outer circumference of the second insulation surface 137 toward the outer circumference of the first insulation surface 136. The inner circumferential surface 42 of the module frame 40 may include a shape corresponding to the outer circumferential surface 1331 of the insulation and may be disposed to contact the outer circumferential surface 1331 of the insulation.

According to the spirit of the present disclosure, by pressing the cooling sink and the heat sink toward the thermoelectric element, contact between the cooling sink and the thermoelectric element and contact between the heat sink and the thermoelectric element may be effectively achieved, thereby improving the efficiency of heat exchange through the thermoelectric module.

According to the spirit of the present disclosure, the plurality of heat sinks may be reliably connected to each other by the connector, or the plurality of heat sinks may be formed integrally, so that the rigidity of the thermoelectric module may be secured with a simpler structure.

According to the spirit of the present disclosure, the thermoelectric module does not include a separate outer case or the like in forming the thermoelectric module, the thermoelectric module may be lightweight.

According to the spirit of the present disclosure, since the connector connecting the plurality of thermoelectric modules is detachable, only thermoelectric modules requiring maintenance and repair may be easily separated, thereby increasing the efficiency of management.

According to the spirit of the present disclosure, the outer circumferential surface of the insulation and the inner circumferential surface of the module frame in contact therewith are formed to be inclined, so that the plurality of thermoelectric modules may be more reliably seated on the insulating wall.

According to the spirit of the present disclosure, the thermoelectric module may be separated from the module frame by only separating the fixing member connecting the heat sink and the module frame, thereby improving the mounting convenience of the thermoelectric module.

The effects that can be obtained with the present disclosure are not limited to those mentioned above, and other effects not mentioned will be apparent to those having ordinary knowledge in the technical field to which the present disclosure belongs from the following description.

Although the above technical ideas of the disclosure have been described by way of specific embodiments, the scope of the disclosure is not limited to these embodiments. Various modifications and variations that can be made by those skilled in the art without departing from the technical ideas of the disclosure as set forth in the claims of the patent will be deemed to be within the scope of the disclosure.

## Claims

1. A refrigerator comprising:
a main body including an insulating wall having a hole therethrough;
a storage compartment in the main body; and
a thermoelectric module in the hole, seated on the insulating wall, and configured to cool the storage compartment;
wherein the thermoelectric module includes:
a thermoelectric element including a heat-absorbing surface on a first side of the thermoelectric module facing the storage compartment and configured to absorb heat from the storage compartment, and a heat-generating surface on a second side of the thermoelectric module, opposite the first side, and configured to receive heat from the heat-absorbing surface and discharge the received heat,
a cooling sink in contact with the heat-absorbing surface and configured to exchange heat with the heat-absorbing surface,
a heat sink in contact with the heat-generating surface and configured to exchange heat with the heat-generating surface, and
a coupling member coupling the cooling sink and the heat sink so that the cooling sink is pressed against the heat-absorbing surface and the heat sink is pressed against the heat-generating surface.

2. The refrigerator of claim 1, wherein
the cooling sink has a cooling sink coupling hole therethrough,
the heat sink has a heat sink coupling hole therethrough, and
the coupling member includes:
a first coupling portion passing through the cooling sink coupling hole and the heat sink coupling hole,
a second coupling portion connected to a first end of the first coupling portion and configured to be supported on the first side of the thermoelectric module, and
a third coupling portion connected to a second end of the first coupling portion and configured to be supported on the second side of the thermoelectric module, and
the second coupling portion or the third coupling portion is configured to be movable toward the thermoelectric element to press the cooling sink against the heat-absorbing surface and to press the heat sink against the heat-generating surface.

3. The refrigerator of claim 2, wherein
the first coupling portion includes a bolt body,
the second coupling portion includes a nut, and
the third coupling portion includes a bolt head.

4. The refrigerator of claim 1, further comprising:
a module frame along an inner circumferential surface of the hole and secured to the insulating wall,
wherein the thermoelectric module is coupled to the module frame.

5. The refrigerator of claim 1, wherein
the thermoelectric module includes a plurality of thermoelectric modules, and
the refrigerator includes at least one connector connecting the plurality of thermoelectric modules to each other.

6. The refrigerator of claim 5, wherein
the plurality of thermoelectric modules includes a plurality of heat sinks, and
the at least one connector connects the plurality of thermoelectric modules to each other by coupling to the plurality of heat sinks to each other.

7. The refrigerator of claim 6, wherein the connector is coupled to a side of each heat sink of the plurality of heat sinks that faces away from the storage compartment.

8. The refrigerator of claim 4, further comprising:
an insulation having a through hole,
wherein the thermoelectric element is in the through hole, and the insulation is between the cooling sink and the heat sink.

9. The refrigerator of claim 8, wherein
the insulation includes:
a first cover plate covering a first insulation surface that faces the cooling sink, and
a second cover plate covering a second insulation surface that faces the heat sink, and
the first cover plate contacts a side of the cooling sink facing the insulation, and the second cover plate contacts a side of the heat sink facing the insulation.

10. The refrigerator of claim 8, wherein an outer circumferential surface of the insulation contacts an inner circumferential surface of the module frame.

11. The refrigerator of claim 10, wherein
the insulation includes:
a first insulation surface facing the cooling sink, and
a second insulation surface facing the heat sink,
the first insulation surface has a smaller area than the second insulation surface,
an outer circumferential surface of the insulation is inclined from an outer circumference of the second insulation surface toward an outer circumference of the first insulation surface, and
an inner circumferential surface of the module frame includes a shape corresponding to the outer circumferential surface of the insulation and is in contact with the outer circumferential surface of the insulation.

12. The refrigerator of claim 9, wherein
the cooling sink includes:
a cooling plate contacting the first cover plate, and
a cooling block protruding from the cooling plate into the through hole,
the heat sink includes a heating plate contacting the second cover plate, and
the thermoelectric element is arranged so that the heat-absorbing surface contacts the cooling block and the heat-generating surface contacts the heating plate.

13. The refrigerator of claim 1, wherein
the insulating wall includes:
an inner opening on a first side of the insulating wall facing toward the storage compartment, and
an outer opening on a second side of the insulating wall facing away from the storage compartment, opposite to the first side,
the hole extends from the inner opening to the outer opening, and
the thermoelectric element is closer to the outer opening than the inner opening.

14. The refrigerator of claim 4, wherein the heat sink is secured to the module frame to couple the thermoelectric module to the module frame.

15. The refrigerator of claim 1, wherein
the cooling sink has a cooling sink coupling hole therethrough,
the heat sink has a heat sink coupling hole therethrough,
the thermoelectric module includes:
a first cover covering outside a circumference of the cooling sink coupling hole on a side of the cooling sink, and
a second cover covering outside a circumference of the heat sink coupling hole on a side of the heat sink, and
the first cover and the second cover include an insulating material.
